# EUROPEAN PATENT APPLICATION

(11) **EP 2 408 031 A2**
(43) Date of publication of application: **18.01.2012**
(21) Application number: 11174170.8
(22) Date of filing: 15.07.2011
(51) Int. Cl.: H01L 33/62, H01L 33/48, H01L 33/64

(54) **Light emitting diode package and frame shaping method of the same**

(30) Priority: 15.07.2010 TW 099123284
(71) Applicant: Lextar Electronics Corp., 30075 Hsinchu (TW)
(72) Inventor: Chen, Chang-Han, 305 Hsinchu County (TW); Hsu, Chin-Chang, 900 Pingtung County (TW)
(74) Representative: von Kreisler, Alek

(57) **Abstract**

A single material tape is shaped into first, second and third frames isolated from and disposed opposite each other, and a press forming process is performed to thin bottoms of first and second wire-bonding sectors extending from the first and second frames. The thickness of each of the first and second wire-bonding sectors is smaller than that of the third frame, so that the thicker third frame can be exposed out of a glue body to achieve the better dissipation effect, and at least one side surface between the two frames isolated from and disposed opposite each other is formed with a slot portion. When the frame is applied to the light emitting diode and fixed to the glue body, the slot portion can increase the bonding property between the frame and the glue body, and the structural strength therebetween can be increased.

## Description

This application claims the benefit of Taiwan application Serial No. 99123284, filed July 15, 2010, the subject matter of which is incorporated herein by reference.

### BACKGROUND OF THE INVENTION

### Field of the Invention

The invention relates in general to a frame shaping method, and more particularly to a frame structure applied to a light emitting diode, wherein frames forms with different thicknesses and a slot portion can be formed from the same material tape, the thicker frame can be exposed out of a glue body to achieve the better dissipation effect, and the slot portion can enhance the molding property between the frame and the glue body and increase the structural strength of the light emitting diode.

### Description of the Related Art

A light emitting diode is a solid-state semiconductor element, wherein the current flows through the diode to generate two carriers combined together, and the energy is released in the form of light. The light emitting diode has the advantages of the small size, the light and handy property and the high response speed and has no pollution, so that the light emitting diodes are gradually applied to different fields. In the early developing stage, the bottlenecks of the insufficient luminance and the low light emitting efficiency are encountered, but the subsequently developed high-power light emitting diode solves the problem of the insufficient luminance, so that the diode gradually enters the high-efficiency illumination light source market and tends to gradually replace the conventional tungsten wire bulb. So, the light emitting diode is a potential product for replacing the conventional illumination. With the continuous improvement of the manufacturing technology of the light emitting diode and the development of the new materials, the subsequently developed high-power light emitting diode has the greatly increased energy efficiency, and the current flowing through per unit area is increased so that the heat generated by the chip is gradually increased. Thus, the environment around the chip becomes the best heat dissipating range. However, the material for packaging the light emitting diode is usually the resin compound having the heat insulating effect and thus the poor thermoconductive effect. Thus, if the resin compound covers the overall die and electrode loop, the heat dissipation becomes unsmooth, and the resin compound tends to create a closed and insulating environment. In addition, the light emitting diode has no structure particularly designed for the heat dissipation, so that the heat is directly dissipated through the circuit according to the thermoconductive property of the electrode loop, and the electrode loop generates the higher thermal resistance to further decrease the light emitting efficiency of the light emitting diode.

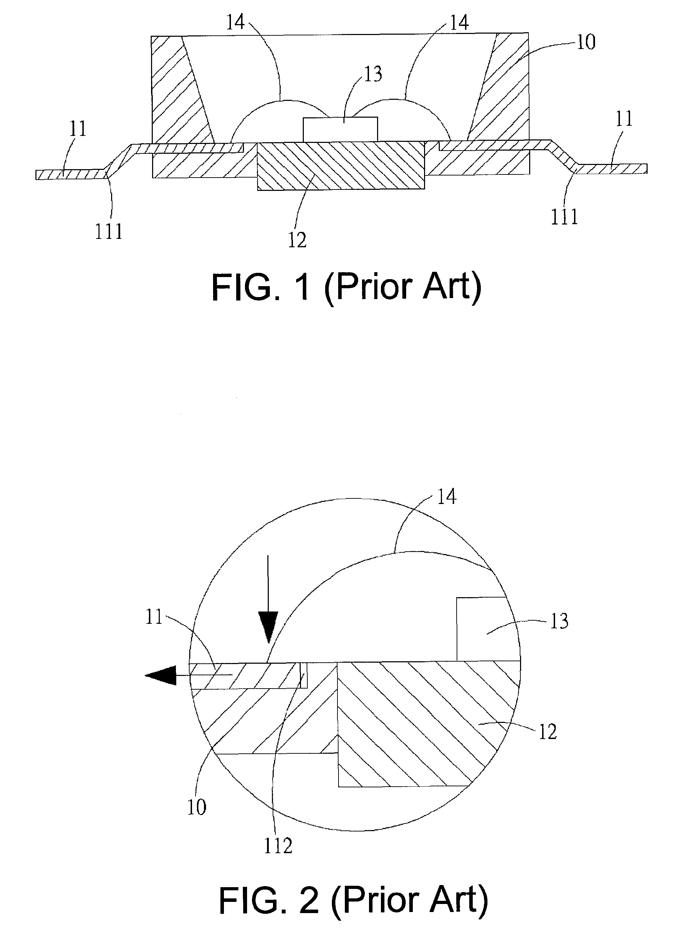

In view of the drawbacks of the above-mentioned structure, FIG. 1 discloses a light emitting diode structure, in which an insulation glue body 10 serves as a main body, and a plurality of electrode pins 11, extending from the inside of the insulation glue body 10 to the outside thereof, is disposed in the insulation glue body 10. The insulation glue body 10 is fixedly mounted to a heat dissipating base 12, on which a light emitting diode chip 13 is placed. The chip 13 is electrically connected to the pin 11 through a wire 14. So, when the light emitting diode is operating, the heat generated thereby is dissipated from the bottom of the chip 13 through the heat dissipating base 12. Meanwhile, the insulation glue body 10 insulates the electrode loop from the heat conducting path to prevent the heat, generated by the chip 13, from transferring through the electrode loop serving as a thermoconductive path to generate the higher thermal resistance, which disables the light emitting diode chip 13 from operating at the normal working temperature.

Although the structure of the insulation glue body 10 solves the heat dissipating problem, the overall structure still has the following drawbacks.

First, the electrode pin and the heat dissipating base have the difference in thickness, and two material tapes with different thicknesses have to be used to form the electrode pin and the heat dissipating base so that the cost thereof is higher.

Second, the electrode pin 11 can be bent in different directions to form the bending portion 111 according to the requirements, so that the top view or side view lighting can be formed. During the bending process, however, a horizontal normal force is exerted on the electrode pin 11 so that the electrode pin 11 is stretched toward the outside of the insulation glue body 10 and the electrode pin 11 tends to be separated from the insulation glue body 10, as shown in FIG. 2, to produce a gap 112, which affects the structural strength of the connection between the electrode pin 11 and the insulation glue body 10.

Third, as for the electrode pin 11, when the wire 14 is being bonded, the vertical normal force exerted on the electrode pin 11 tends to oscillate the electrode pin 11 and affect the process stability.

### SUMMARY OF THE INVENTION

The present invention is a frame shaping method and a structure thereof, which is mainly applied to a frame of a light emitting diode, wherein frames with different thicknesses and a slot portion can be formed from the same material tape, the thicker frame can be exposed out of the glue body to achieve the better dissipation effect, and the slot portion can enhance the molding property between the frame and the glue body and increase the luminous intensity and structural strength of the light emitting diode.

According to the present invention, a single material tape is shaped into first, second and third frames isolated from and disposed opposite each other, and a press forming process is performed to thin bottoms of first and second wire-bonding sectors extending from the first and second frames. The thickness of each of the first and second wire-bonding sectors is smaller than that of the third frame, so that the thicker third frame has the better dissipation effect.

Furthermore, at least one side surface between the two frames isolated from and disposed opposite each other may be formed with a slot portion formed by a plurality of sectors surrounding the slot portion. The first sector slantingly extends from one side surface of the frame toward the inside and the top surface of the frame, and the second sector is connected to the first sector and slantingly extends to the bottom surface toward the inside of the frame. When the frame is applied to the light emitting diode and fixed to the glue body, the slot portion can increase the molding property between the frame and the glue body, and the structural strength therebetween can be increased.

The above and other aspects of the invention will become better understood with regard to the following detailed description of the preferred but non-limiting embodiment(s). The following description is made with reference to the accompanying drawings.

### BRIEF DESCRIPTION OF THE DRAWINGS

FIG. 1 (Prior Art) is a schematic illustration showing a conventional structure of a light emitting diode.

FIG. 2 (Prior Art) is a schematic illustration showing an enlarged structure of the conventional light emitting diode.

FIGS. 3A to 3C are schematic illustrations showing shaping of a frame according to a preferred embodiment of the invention.

FIG. 4 is a pictorial view showing a backside structure of the frame according to the preferred embodiment of the invention.

FIG. 5 is a schematic illustration showing a structure of a slot portion according to the preferred embodiment of the invention.

FIG. 6 is a schematic illustration showing a structure of a slot portion according to another embodiment of the invention.

FIG. 7 is a pictorial view showing a structure of a light emitting diode according to the preferred embodiment of the invention.

FIG. 8 is a cross-sectional view showing the structure of the light emitting diode according to the preferred embodiment of the invention.

FIG. 9 is a schematic illustration showing a backside structure of the light emitting diode according to the preferred embodiment of the invention.

### DETAILED DESCRIPTION OF THE INVENTION

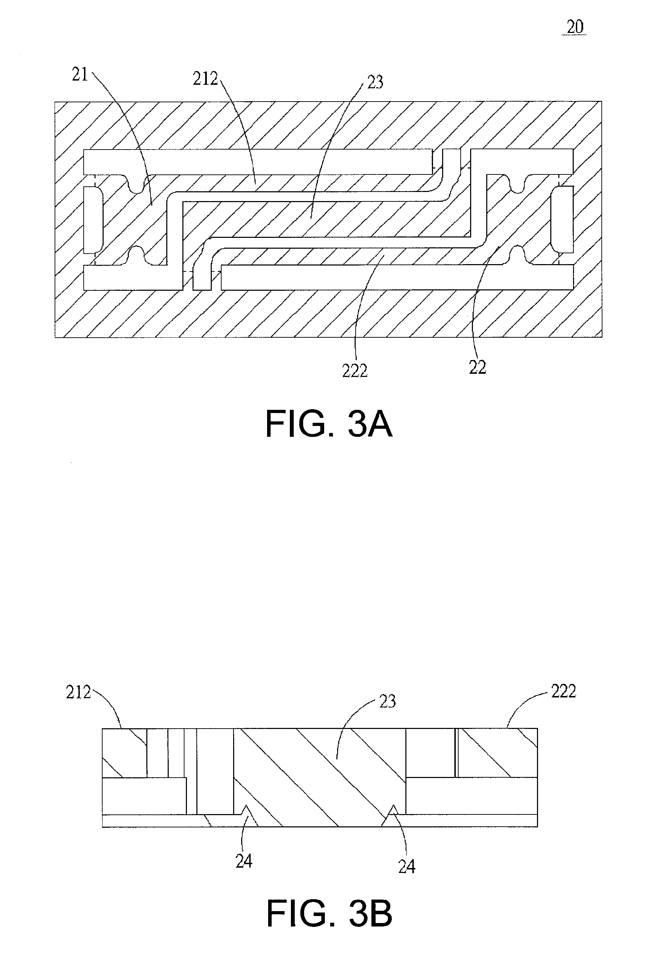

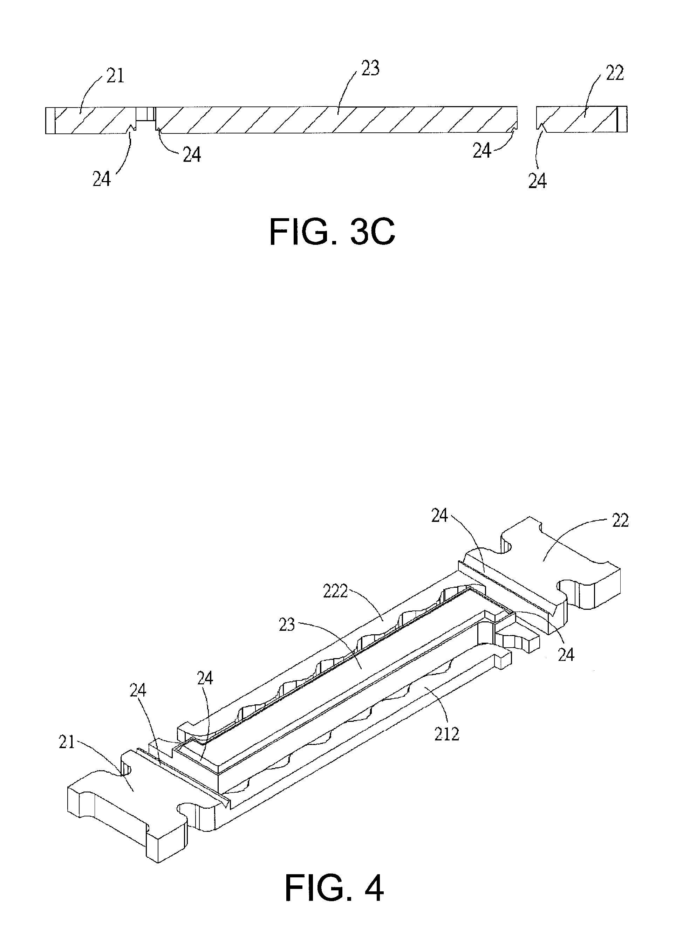

The invention provides a light emitting diode, its frame shaping method and an improved frame structure. FIGS. 3A to 3C are schematic illustrations showing shaping of a frame according to a preferred embodiment of the invention. FIG. 4 is a pictorial view showing a backside structure of the frame according to the preferred embodiment of the invention. As shown in FIGS. 3A to 3C and 4, the frame shaping method of the invention includes the following steps. In step A, a metal material tape 20 is provided. In step B, a first press forming process is performed to form first, second and third frames 21, 22 and 23 isolated from and disposed opposite each other, as shown in FIG. 3A. First and second wire-bonding sectors 212 and 222 respectively extend from the first and second frames 21 and 22 along side edges of the third frame 23. In step C, a second press forming process is performed to form a slot portion 24 on at least one side surface between the two frames isolated from and disposed opposite each other, as shown in FIGS. 3B, 3C and 4. The bottoms of the first and second wire-bonding sectors 212 and 222 are thinned so that the thickness of each of the first and second wire-bonding sectors 212 and 222 is smaller than the thickness of the third frame 23.

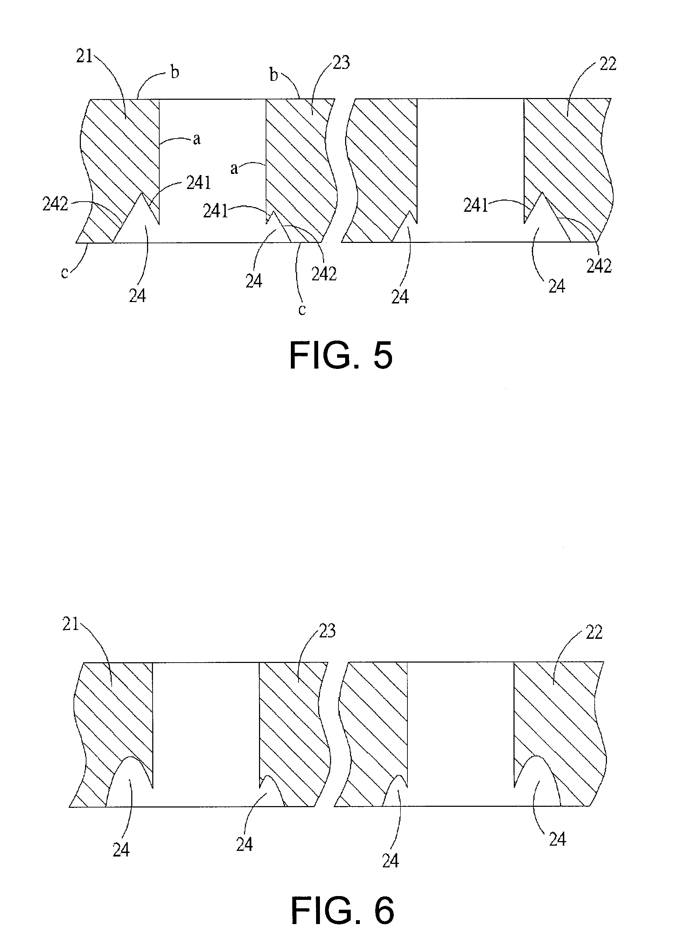

In the embodiment shown in the drawings, the slot portion 24 is formed on at least one of the side surfaces between the first and third frames 21 and 23 and between the third and second frames 23 and 22. The slot portion 24 is formed by a plurality of sectors surrounding the slot portion. In the embodiment shown in FIG. 5, the linear first and second sectors 241 and 242 are provided, wherein the first sector 241 slantingly extends from a side surface "a" of the frame 21/22/23 toward the inside of the frame 21/22/23 and the top surface "b", and the second sector 242 connected to the first sector 241 slantingly extends to the bottom surface "c" toward the inside of the frame 21/22/23. Of course, each of the sectors 241 and 242 may also be an arc sector (see FIG. 6) or a combination of a linear sector and an arc sector.

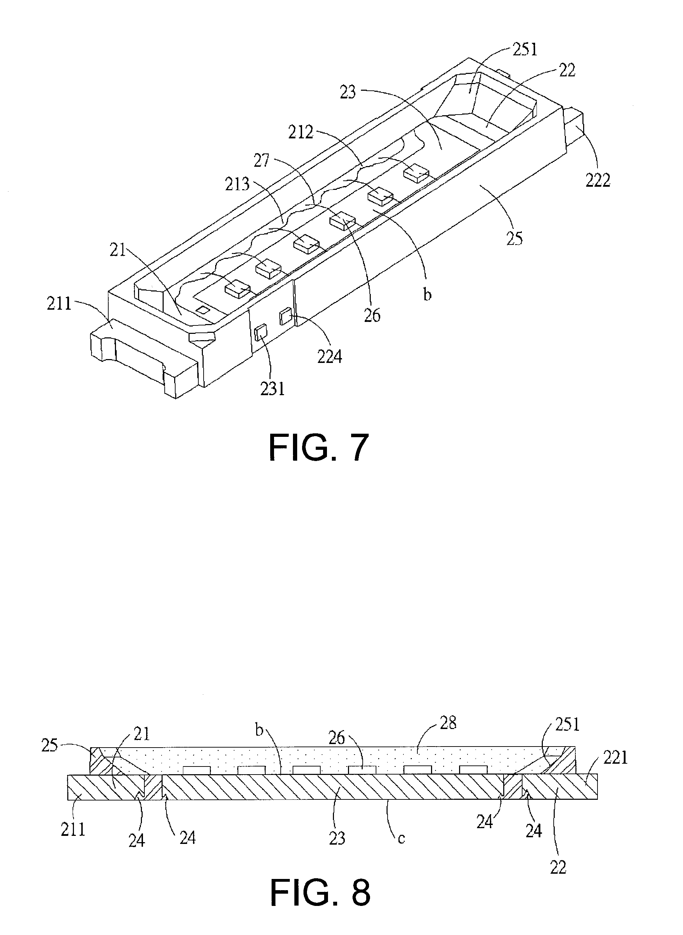

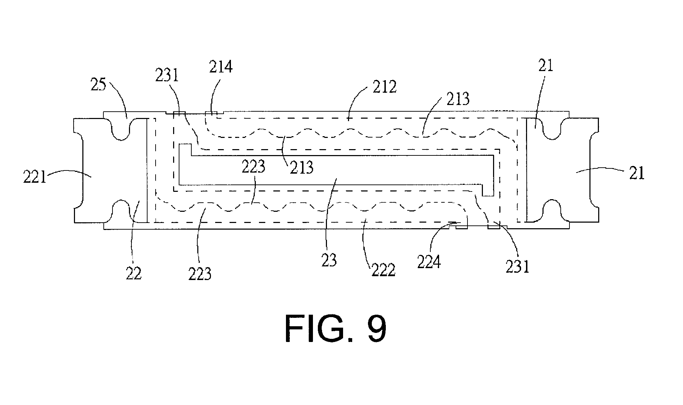

The frame of the invention may be applied to a light emitting diode, as shown in FIGS. 7 to 9. FIG. 7 is a pictorial view showing a structure of a light emitting diode according to the preferred embodiment of the invention. FIG. 8 is a cross-sectional view showing the structure of the light emitting diode according to the preferred embodiment of the invention. FIG. 9 is a schematic illustration showing a backside structure of the light emitting diode according to the preferred embodiment of the invention. The structure of the light emitting diode has at least the first, second and third frames 21, 22 and 23 ,each frame21/22 /23 isolated from and disposed opposite other, and each of the first, second and third frames 21, 22 and 23 is partially fixed into a glue body 25. The glue body 25 has one end formed with a concave function area 251. The first and second frames 21 and 22 extend to the outside of the glue body 25 from the function area 251 to form pin portions 211 and 221. The third frame 23 is disposed in the function area 251 and has a top surface 'b' exposed to the function area 251 and a bottom surface 'c' exposed to the glue body 25. The slot portion 24 is formed on at least one side surface between the two frames (between the first and second frames 21 and 22 and between the second and third frames 22 and 23) isolated from and disposed opposite each other.

The first and second wire-bonding sectors 212 and 222 respectively extend from the first and second frames 21 and 22 along the side edges of the third frame 23, and at least one light emitting diode chip 26 is fixed to the top surface b of the third frame 23. Each of the light emitting diode chip 26 is connected to the first and second wire-bonding sectors 212 and 222 by a wire 27, and an encapsulant 28 is disposed in the function area of the glue body 25 to cover each light emitting diode chip 26.

When each light emitting diode chip 26 of the invention is powered on to emit light, the heat generated by each light emitting diode chip 26 may be dissipated out through the metal third frame 23 and the bottom surface "c" exposed to the outside of the glue body 25. The third frame 23 is thicker and is exposed out of the glue body, and thus has the better dissipation effect, and the first, second and third frames 21, 22 and 23 are shaped from a single material tape without using two material tapes with different thicknesses. The slot portion 24 is disposed at the connection between each of the frames 21, 22 and 23 and the glue body 25. The provision of the slot portion 24 can increase the molding property between each of the frames 21, 22 and 23 and the glue body 25, and the structural strength therebetween can be increased. Furthermore, the area of the slot portion 24 disposed on the two side surfaces of the third frame 23 is slightly smaller than the area of the slot portion 24 of each of the first and second frames 21 and 22, as shown in FIG. 5, so that the provision of the slot portion 24 cannot affect the effective dissipation area of the third frame 23.

In addition, in each frame press forming process, at least one convex portion 213/223 may be disposed on the first and second wire-bonding sectors 212 and 222 near the third frame 23, as shown in FIG. 9, to only increase the wire bonding area and also shorten the wire bonding distance. The first and second wire-bonding sectors 212 and 222 and the third frame 23 are formed with fixing portions 214, 224 and 231 extending into the glue body 25, as shown in FIGS. 7 and 9, so that the process stability can be effectively kept constant.

While the invention has been described by way of example and in terms of the preferred embodiment(s), it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A frame shaping method of a light emitting diode, the method comprising the steps of:
(a) providing a metal material tape;
(b) performing a first press forming process to form a first, a second and a third frames isolated from and disposed opposite each other, wherein a first and a second wire-bonding sectors extend from the first and second frames along side edges of the third frame; and
(c) performing a second press forming process to form a slot portion on at least one side surface between the two frames isolated from and disposed opposite each other, wherein bottoms of the first and second wire-bonding sectors are thinned so that a thickness of each of the first and second wire-bonding sectors is smaller than a thickness of the third frame.

2. The method according to claim 1, wherein the slot portion is formed by a plurality of sectors surrounding the slot portion, a first sector of the sectors slantingly extends from the side surface of the frame toward inside and a top surface of the frame, and a second sector of the sectors is connected to the first sector and slantingly extends to a bottom surface toward the inside of the frame.

3. The method according to claim 1 or 2, wherein at least one convex portion is disposed on the first and second wire-bonding sectors near the third frame.

4. An light emitting diode structure, comprising:
a glue body, wherein an inside of an end of the glue body has a concave function area; and
at least one first, at least one second and at least one third frames isolated from and disposed opposite each other, wherein each of the first, second and third frames is partially fixed into the glue body, the first and second frames extend from the function area to outside of the glue body to form pin portions, the third frame is disposed in the function area, a top surface of the third frame is exposed to the function area, a bottom surface of the third frame is exposed the glue body, a slot portion is formed on at least one side surface between the two frames isolated from and disposed opposite each other, the slot portion is formed by a plurality of sectors surrounding the slot portion, a first sector of the sectors slantingly extends from a side surface of the frame toward inside and the top surface of the frame, and a second sector of the sectors is connected to the first sector and slantingly extends to the bottom surface toward the inside of the frame.

5. The light emitting diode structure according to claim 4, wherein the shape of each of the sectors comprises at least one of a linear shape and arc shape.

6. The light emitting diode structure according to claim 4 or 5, wherein a first and a second wire-bonding sectors extend from the first and second frames along side edges of the third frame respectively.

7. The light emitting diode structure according to claim 6, wherein at least one convex portion is formed on the first and second wire-bonding sectors near the third frame.

8. The light emitting diode structure according to claim 6, wherein the first and second wire-bonding sectors and the third frame are formed with fixing portions extending into the glue body.

9. The light emitting diode structure according to one of claims 4-8, further comprising:
at least one light emitting diode chip fixed to a top surface of the third frame, wherein the light emitting diode chip is connected to the first and second wire-bonding sectors by wires.

10. The light emitting diode structure according to one of claims 4-9, further comprising:
an encapsulant disposed in the function area of the glue body to cover the light emitting diode chip.
